# EUROPÄISCHE PATENTANMELDUNG

(11) **EP 4 306 970 A1**
(43) Veröffentlichungstag der Anmeldung: **17.01.2024**
(21) Anmeldenummer: 22184707.2
(22) Anmeldetag: 13.07.2022
(51) Int. Cl.: G01R 19/00, H03K 17/12

(54) **VORRICHTUNG UND VERFAHREN ZUR INSPEKTION UND/ODER ÜBERWACHUNG VON STROM EINER PHASE**

(71) Anmelder: Siemens Aktiengesellschaft, 80333 München (DE)
(72) Erfinder: Jungwirth, Thomas, 91301 Forchheim (DE); Kunert, Andreas, 90522 Oberasbach (DE); Lorz, Roland, 91341 Röttenbach (DE); Namyslo, Lutz, 91353 Hausen (DE)
(74) Vertreter: Siemens Patent Attorneys

(57) **Zusammenfassung**

Die Erfindung betrifft eine Vorrichtung zur Inspektion und/oder Überwachung von Strom (I_{U}, I_{V}, I_{W}) einer Phase (U, V, W) in einer Leistungselektronik-Vorrichtung (30), wobei die Leistungselektronik-Vorrichtung (30) mindestens zwei Leistungshalbleitermodule (LM1, LM2) aufweist, wobei die mindestens zwei Leistungshalbleitermodule (LM1, LM2) an der Phase (U, V, W) parallelgeschaltet angeordnet sind, wobei die Vorrichtung (MV) mindestens zwei Stromerfassungsvorrichtungen (SV1, SV2), mindestens zwei Wandlungseinheiten (ADW1, ADW2), und eine Auswerteeinrichtung (ED) umfasst, wobei jede Stromerfassungsvorrichtung (SV1, SV2) dazu ausgebildet ist, Teilstrom (TS1, TS2) an jeweils einem Leistungshalbleitermodul (LM1, LM2) zu erfassen und ein analoges Signal (AS1, AS2), das dem erfassten Teilstrom (TS1, TS2) korrespondiert, auszugeben, wobei eine Summe aller erfassten Teilströme (TS1, TS2) den Strom (I_{U}, I_{V}, I_{W}) in der Phase (U, V, W) ergibt, wobei jede Wandlungseinheit (ADW1, ADW2) jeweils einer Stromerfassungsvorrichtung (SV1, SV2) nachgeschaltet ist und dazu ausgebildet ist, das analoge Signal (AS1, AS2) in ein digitales Signal (S1, S2) umzuwandeln, wobei die Auswerteeinrichtung (ED) den mindestens zwei Wandlungseinheiten (ADW1, ADW2) nachgeschaltet ist und dazu ausgebildet und eingerichtet ist, basierend auf den digitalen Signalen (S1, S2) ein Ausgangssignal zu erzeugen, das eine regelungsrelevante und/oder diagnostisch relevante Information über den Strom (I_{U}, I_{V}, I_{W}) der Phase (U, V, W) enthält.

## Beschreibung

Die Erfindung betrifft eine Vorrichtung und Verfahren zur Inspektion und/oder Überwachung von Strom einer Phase in einer Leistungselektronik-Vorrichtung, vorzugsweise in einem Umrichter, beispielsweise in einem Stromrichter, insbesondere in einem Wechselrichter oder in einem Frequenzumrichter, wobei die Leistungselektronik-Vorrichtung mindestens zwei Leistungshalbleitermodule aufweist, wobei die mindestens zwei Leistungshalbleitermodule an der Phase parallelgeschaltet angeordnet sind.

Darüber hinaus betrifft die Erfindung eine elektronische Baugruppe mit einer solchen Vorrichtung.

Obendrein betrifft die Erfindung eine Leistungselektronik-Vorrichtung, insbesondere einen Umrichter, insbesondere einen Frequenzumrichter oder Wechselrichter mit einer solchen elektronischen Baugruppe.

Zum Betrieb der Stromregelung bei Leistungselektronik-Vorrichtungen wird der Stromistwert der Stromphase, insbesondere jeder einzelnen Stromphase, wenn es mehrphasiger Betrieb in Frage kommt, benötigt. Dabei wird der Stromausgang z.B. der Stromistwert einer Phase, oder Stromistwert eines DC/DC-Wandlers, der auch einphasig ausgeführt werden kann (eine einzige Phase), gemessen.

Zur Erhöhung der Leistung von Frequenzumrichtern ist die Parallelschaltung von mehreren Leistungshalbleitermodulen (üblich zwei bis sechs, in Ausnahmefällen bis maximal zehn) eine übliche und etablierte Lösung. Dabei wächst die Leistung, der Strom proportional mit der Anzahl der parallelgeschalteten Leistungshalbleitermodule. Dadurch können beispielsweise Umrichter bereitgestellt werden, die in einem Leistungsbereich zwischen 0,55 kW und 1,5 MW oder mehr, insbesondere zwischen 100 kW und 250,00 kW, vorzugsweise zwischen 150 kW und 200 kW, arbeiten können.

Die für die Regelung des Frequenzumrichters notwendige Erfassung des Phasenstromes erfolgt dabei meist über einen zentralen Messwandler, d.h. ein Messwandler pro Phase. Bekannt sind beispielsweise Stromwandler, Wandler der Firma LEM, z.B. aus der Klasse der direktabbildenden Hall-Effekt-Stromsensoren - HTA-S. Es sind jedoch eine Vielzahl weiterer kommerzieller Lösungen am Markt erhältlich.

Bei einer geringen Anzahl von parallel geschalteten Leistungshalbleitermodulen (bis maximal drei) ist auch eine dezentrale Erfassung der Ströme (im Leistungshalbleitermodulen oder in dessen unmittelbaren Nähe), d.h. eine Erfassung von Teilströmen der einzelnen parallelgeschalteten Module, anstatt des Phasengesamtstromes bekannt. Diese kann z.B. über Shunt-Messung erfolgen. Mit der "unmittelbaren Nähe" ist gemeint, dass man beim Anbringen der Shunts der EMV (elektromagnetische Verträglichkeit) Problematik Rechnung tragen soll. Im Kontext der vorliegenden Offenbarung kann die "unmittelbare Nähe" wenige Centimeter, z.B. 1 bis 10 cm, bedeuten. Die dezentral erfassten Ströme jedes Leistungshalbleitermoduls können dann über eine analoge Schaltung addiert werden, um den Gesamtphasenstrom zu erhalten. Die analoge Addition von Teilströmen, insbesondere bei großen Leistungen und Spannungen und in Kombination einer Shunt-Widerstands Messung, ist bezüglich der Störfestigkeit und der Übertragung bis zur Regelungseinheit kritisch. Eine analoge Addition der Ströme von mehr als drei Leistungshalbleitermodulen wird als äußerst aufwendig und nicht praktikabel eingeschätzt.

Die zu diesen Messungen dazugehörige Signalverarbeitung (Addition, Übertragung, etc.) ist allerdings sehr störanfällig. Außerdem stehen in dem ersten Fall keine Information darüber, wie sich die Ströme innerhalb der Modulparallelschaltung aufteilen, sodass sich über den Zustand der entsprechenden einzelnen Leistungshalbleitermodule kaum eine Aussage treffen lässt. Im zweiten Fall liefert die analoge Addition ungenaue und unzuverlässige Messergebnisse.

Der vorliegenden Erfindung liegt also die Aufgabe zugrunde, Vorrichtungen und Verfahren bereitzustellen, die eine verbesserte Inspektion und/oder Überwachung des Phasenstroms ermöglichen.

Die Aufgabe wird mit einer eingangs genannten Vorrichtung dadurch gelöst, dass die Vorrichtung mindestens zwei Stromerfassungsvorrichtungen, mindestens zwei Wandlungseinheiten, und eine Auswerteeinrichtung umfasst.

Die Leistungselektronik-Vorrichtung, vorzugsweise der Umrichter, beispielsweise der Stromrichter, insbesondere der Wechselrichter oder der Frequenzumrichter kann beispielsweise zur Versorgung einer elektrischen, insbesondere rotatorischen Maschine, beispielsweise eines Drehstrom-Asynchronmotors ausgebildet sein.

Es ist auch denkbar, dass die Leistungselektronik-Vorrichtung für einen Netzbetrieb ausgebildet ist, zum Beispiel für Einspeisungen bzw. im DC-DC-Wandler Betrieb (Transformator, Netz, etc.)

Dabei ist jede Stromerfassungsvorrichtung dazu ausgebildet, Teilstrom an oder in jeweils einem, vorzugsweise an oder in genau einem Leistungshalbleitermodul der an der Phase parallelgeschaltet angeordneten Leistungshalbleitermodule zu erfassen und ein analoges Signal, das dem erfassten Teilstrom korrespondiert bzw. diesen abbildet, auszugeben. Eine Summe aller erfassten Teilströme ergibt den Strom in der Phase - also den Gesamtphasenstrom

Darüber hinaus ist jede Wandlungseinheit jeweils einer, vorzugsweise genau einer Stromerfassungsvorrichtung nachgeschaltet und dazu ausgebildet, das analoge Signal in ein digitales Signal umzuwandeln. In einer vorteilhaften Ausgestaltung ist jede Wandlungseinheit dazu ausgebildet, das analoge Signal in ein serielles Digitalsignal mit einer Sigma-Delta-Codierung umzuwandeln. Vorzugsweise ist das digitale Signal ein 1-Bit-Datenstrom.

Die Auswerteeinrichtung ist den mindestens zwei Wandlungseinheiten nachgeschaltet. Sie ist dazu ausgebildet und eingerichtet (konfiguriert), basierend auf den digitalen Signalen zumindest ein Ausgangssignal zu erzeugen, das eine regelungsrelevante und/oder diagnostisch relevante Information über den Strom der Phase - also über den Gesamtstrom - trägt.

Die Auswerteeinrichtung ist also hardwaretechnisch dazu ausgebildet, basierend auf den digitalen Signalen zumindest ein Ausgangssignal zu erzeugen, das eine regelungsrelevante und/oder diagnostisch relevante Information über den Strom der Phase trägt. D.h. die Auswerteeinrichtung verfügt beispielsweise über genügende Anzahl der Pins usw.

Die Auswerteeinrichtung ist auch softwaretechnisch dazu konfiguriert, basierend auf den digitalen Signalen zumindest ein Ausgangssignal zu erzeugen, das eine regelungsrelevante und/oder diagnostisch relevante Information über den Strom der Phase trägt. D.h. die Auswerteeinrichtung umfasst beispielsweise Programmcode(mittel), die sie befähigen, das zumindest eine Ausgangsignal basierend auf den digitalen Signalen zu erzeugen.

Die Auswerteeinrichtung bekommt also die (einzelnen) digitalen Signale als Input und wandelt sie vorzugsweise in das zumindest eine Ausgangssignal um.

Im Rahmen der vorliegenden Offenbarung wird unter dem Begriff "Phase" ein Phasenleiter (auch ein Außenleiter genannt) verstanden.

Beispielsweise arbeitet das heute weltweit übliche Wechselstrom-Versorgungssystem nicht mit einem, sondern mit drei stromführenden Leitern (Außenleiter, Phasenleiter), wobei die Phasen der einzelnen Ströme, welche dieselbe Frequenz aufweisen, um 120° gegeneinander versetzt sind. Man spricht von Dreiphasen-Wechselstrom, von Drehstrom oder von Starkstrom. Die einzelnen Leiter werden als typischerweise U, V, und W bzw. L1, L2, und L3 bezeichnet (manchmal auch als R, S, und T) .

Bei einer Ausführungsform kann es vorgesehen sein, dass zumindest ein Leistungshalbleitermodul, vorzugsweise jedes Leistungshalbleitermodul als ein IGBT-Modul (in engl.: *insulated-gate bipolar transistor module*) ausgebildet ist.

Bei einer Ausführungsform kann es zweckdienlich sein, mehrere Wandlungseinheiten vorzusehen. In diesem Fall kann es zweckmäßig sein, dass die Auswerteeinrichtung allen Wandlungseinheiten nachgeschaltet ist.

Bei einer Ausführungsform kann es vorgesehen sein, dass mehrere digitale Signale erzeugt werden. In diesem Fall kann es zweckmäßig sein, dass die Auswerteeinrichtung aus allen digitalen Signalen gemeinsam ein Ausgangssignal generiert.

Die Vorrichtung ist vorzugsweise als eine elektronische Schaltung bzw. als ein Teil einer elektronischen Schaltung ausgebildet.

Bei einer Ausführungsform kann es vorgesehen sein, dass jede Stromerfassungsvorrichtung zumindest einen Strommesswiderstand - einen Shuntwiderstand, vorzugsweise zwei oder mehr Strommesswiderstände, oder einen Stromsensor, beispielsweise einen GMR-Sensor (für engl.: *giant magneto-resistive sensor*) oder einen Hall-Sensor aufweist.

Bei einer Ausführungsform kann es vorgesehen sein, dass das Ausgangssignal einer Summe der Teilströme korrespondiert. Dabei können die digitalen Signale, die den Teilströmen entsprechen, auf der digitalen Seite (der Wandlungseinheit) summiert werden.

Dabei kann mit Vorteil vorgesehen sein, dass die Auswerteeinrichtung eine digitale Additionskomponente aufweist, wobei die digitale Additionskomponente dazu konfiguriert ist, die digitalen Signale miteinander (digital) zu addieren. Vorteilhaft bei der Ausführung ist, dass die Addition nicht analog ausgeführt ist, sondern im Digitalen erfolgt.

Bei einer Ausführungsform kann es vorgesehen sein, dass die (digitale) Auswerteeinrichtung ein FPGA-Modul umfasst, in welchem die digitale Additionskomponente implementiert ist.

Es ist auch denkbar in einem FPGA-Modul mehrere Additionskomponenten zu implementieren.

Bei einer Ausführungsform kann es vorgesehen sein, dass die Additionskomponente als eine Software-Komponente ausgeführt ist.

Bei einer Ausführungsform kann es vorgesehen sein, dass die (digitale) Auswerteeinrichtung eine weitere Wandlungseinheit aufweist.

Bei einer Ausführungsform kann es vorgesehen sein, dass das Ausgangssignal eine Information über die Symmetrie der Aufteilung des Stroms der Phase auf die Teilströme trägt. Hierdurch wird die Information über die Symmetrie der den Phasenstrom bildenden Teilströme zur Verfügung gestellt.

Bei einer Ausführungsform kann es vorgesehen sein, dass die (digitale) Auswerteeinrichtung zur Detektion einer Asymmetrie in der Aufteilung des Phasenstroms in die Teilströme, und/oder eines Kurzschlusses, und/oder eines Ausfalls eines der Leistungshalbleitermodule und/oder zur Messung eines Stromwertes ausgebildet ist.

Die Auswerteeinrichtung ermöglicht vorzugsweise Daten/Informationen über den Stromfluss durch jedes Leistungshalbleitermodul zu ermittelt und diese verfügbar zu machen. Diese Daten können für Vorhersagen verwendet werden, wodurch Wartungs- und Ausfallkosten eingespart werden können.

Die Auswertung der Teilströme durch die Auswerteeinrichtung eröffnet die Möglichkeit die Aufteilung der Teilströme aktiv zu beeinflussen, insbesondere eine gleichmäßige Aufteilung zwischen den einzelnen Leistungshalbleitermodulen zu erzielen.

Bei einer Ausführungsform kann es vorgesehen sein, dass die Auswerteeinrichtung zumindest eine Inverterkomponente, zumindest eine digitale Additionskomponente, zumindest eine Wandlungseinheit und zumindest eine Zählereinheit umfasst.

Bei einer Ausführungsform kann es vorgesehen sein, dass zumindest eine, vorzugsweise jede Wandlungseinheit als ein Sigma-Delta-Wandler ausgebildet ist und das digitale Signal ein 1-Bit-Datenstrom ist. Dies ermöglicht, eine Umwandlung des analogen in ein digitales Signal.

Insbesondere kann es zweckdienlich sein, wenn der Sigma-Delta-Wandler zusätzlich mit einer Potentialtrennung-Funktionalität ausgestattet ist. Dies ermöglicht gleichzeitige eine Potentialtrennung der Stromistwerte. Hierdurch kann eine hohe Störfestigkeit des Signals für die weitere Übertragung zur Regelungseinheit bzw. digitalen Verarbeitungseinheit des Umrichters erreicht werden.

Es kann dabei zweckmäßig sein, 50mV- oder 200mV-Sigma-Delta-Wandler zu verwenden.

Mit einem 50mV-Sigma-Delta-Wandler kann der Shunt-Widerstandswert und damit auch seine Verlustleistung signifikant reduziert werden.

Bei einer Ausführungsform kann es vorgesehen sein, dass die digitale Additionskomponente dazu ausgebildet ist, einen n-Bit-Datenstrom auszugeben, wobei n die Anzahl der parallelgeschalteten Leistungshalbleitermodule bezeichnet.

Bei einer Ausführungsform kann es vorgesehen sein, dass die Auswerteeinheit dazu ausgebildet ist, den n-Bit-Datenstrom in einen 1-Bit-Datenstrom umzuwandeln. Hierzu kann die Auswerteeinheit eine Wandlungseinheit, insbesondere einen Sigma-Delta-Wandler umfassen, die den n-Bit-Datenstrom in einen 1-Bit-Datenstrom umwandelt.

Darüber hinaus kann es mit Vorteil vorgesehen sein, dass die Auswerteeinheit dazu ausgebildet ist, zusätzlich zu den Datenstrom ein Clock Signal bereitzustellen. Hierdurch kann eine bessere Synchronisierung erzielt werden.

Die Aufgabe wird außerdem mir einer eingangs genannten elektronischen Baugruppe gelöst, die mindestens zwei parallelgeschaltete Leistungshalbleitermodule (pro Phase) und zumindest eine vorstehend beschriebene Vorrichtung umfasst.

Bei einer Ausführungsform kann es vorgesehen sein, dass die mindestens zwei Stromerfassungsvorrichtungen und/oder die mindestens zwei Wandlungseinheiten in die Leistungshalbleitermodule integriert sind.

Das Integrieren der Stromerfassungsvorrichtungen in das Leistungshalbleitermodul ist aus Sicht der Wärmeabfuhr (Kühlung der Stromerfassungsvorrichtungen) vorteilhaft, da diese beispielsweise auf die gleiche Weise wie die Leistungshalbleitermodule gekühlt bzw. mitgekühlt werden können.

Das Integrieren der Wandlungseinheiten in die Leistungshalbleitermodule ermöglicht eine sehr kompakte Bauweise.

Hierdurch kann eine höhere Kompaktheit der Leistungselektronik-Vorrichtung, insbesondere des Umrichters, erzielt und Installationsplatz gespart werden.

Bei einer Ausführungsform kann es vorgesehen sein, dass die mindestens zwei Stromerfassungsvorrichtungen in die Leistungshalbleitermodule integriert und die mindestens zwei Wandlungseinheiten in die Leistungshalbleitermodule nicht integriert sind. Hierdurch können Vorteile beim Aufbau der Baugruppe entstehen, da sie freier gestaltet werden und an konkrete Anwendungen besser angepasst werden kann. Dabei ist es besser, die Wandlungseinheiten an jeweiligen Leistungshalbleitermodulen so anzuordnen, dass die analoge Übertragungsstrecke des Signals möglichst kurzgehalten und gleichzeitig der EMV Problematik Rechnung getragen wird.

Bei einer Ausführungsform kann es vorgesehen sein, dass weder die mindestens zwei Stromerfassungsvorrichtungen noch die mindestens zwei Wandlungseinheiten in die Leistungshalbleitermodule integriert sind.

Dabei können die Stromerfassungsvorrichtungen beispielsweise als separate (von Leistungshalbleitermodulen baulich getrennte) Module ausgebildet sein. Dies hat weitere Vorteile in Hinblick auf die Modularität des Aufbaus.

Es werden eine konsequente Modularisierung der Leistungsmodule und Freiheit im Design ermöglicht, was zu Einsparungen bei Material, Größe, Gewicht und Entwicklungsaufwand und damit zu geringeren Kosten führt.

Es kann mit Vorteil vorgesehen sein, wenn die Baugruppe mehr als zwei, insbesondere drei oder mehr Leistungshalbleitermodule (pro Phase) umfasst, wobei die Anzahl der Stromerfassungsvorrichtungen und/oder die Anzahl der Wandlungseinheiten jeweils gleich der Anzahl der Leistungshalbleitermodule ist. Dabei kann es zweckdienlich sein, wenn pro Leistungshalbleitermodul jeweils eine, vorzugsweise genau Stromerfassungsvorrichtung und eine, vorzugsweise genau Wandlungseinheit vorgesehen ist.

Bei einer Ausführungsform kann es vorgesehen sein, dass die Baugruppe einen als eine Leiterplatte ausgebildeten Träger aufweist, an dem die mindestens zwei parallelgeschalteten Leistungshalbleitermodule, die mindestens zwei Stromerfassungsvorrichtungen, und die mindestens zwei Wandlungseinheiten angebracht sind. Dabei handelt es sich um eine Baugruppe für eine Phase.

Bei einer Ausführungsform kann es vorgesehen sein, dass die Baugruppe für drei Phasen ausgebildet ist. Hierzu kann die Baugruppe einen als eine Leiterplatte ausgebildeten Träger aufweist, an dem mindestens sechs Leistungshalbleitermodule, von welchen jeweils zwei parallelgeschaltet sind, mindestens sechs Stromerfassungsvorrichtungen (pro Leistungshalbleitermodul je eine), und mindestens sechs Wandlungseinheiten (pro Leistungshalbleitermodul je eine) angebracht sind.

Dabei kann es zweckmäßig sein, wenn die Auswerteeinrichtung an dem Träger angebracht ist.

Die Aufgabe wird außerdem mit einem eingangs genannten Verfahren zur Inspektion und/oder Überwachung von Strom an einer Phase dadurch gelöst, dass
- S01:: an jedem der mindestens zwei Leistungshalbleitermodule ein Teilstrom erfasst, wobei eine Summe aller erfassten Teilströme den Strom in der Phase - den Gesamtphasenstrom - ergibt, und daraus analoge, den jeweiligen Teilströmen korrespondierende Signale erzeugt werden;
- S02:: jedes analoge Signal in ein digitales Signal umgewandelt wird;
- S03:: aus den digitalen Signalen zumindest eine regelungsrelevante und/oder diagnostisch relevante Information über den Strom der Phase ermittelt wird.

Bei einer Ausführungsform kann es vorgesehen sein, dass beim Ermitteln der zumindest einen regelungsrelevanten und/oder diagnostisch relevanten Information:
- S030:: Die digitalen Signale digital addiert werden, und
- S031:: ein Stromwertes für die Phase aus dem Ergebnis des digitalen Addierens der digitalen Signale ermittelt wird.

Bei einer Ausführungsform kann es vorgesehen sein, dass beim Ermitteln der zumindest einen regelungsrelevanten und/oder diagnostisch relevanten Information:
Zusätzlich eine Information betreffend eine Asymmetrie in der Aufteilung des Phasenstroms in die Teilströme und/oder einen Kurzschluss und/oder einen Ausfall eines der Leistungshalbleitermodule ermittelt wird.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:
- FIG 1: einen Antriebsstrang nach Stand der Technik,
- FIG 2: eine Messvorrichtung zur Inspektion und/oder Überwachung von Strom einer Phase,
- FIG 3: eine Auswerteeinrichtung der Messvorrichtung der FIG 2,
- FIG 4: eine weitere Auswerteeinrichtung,
- FIG 5: eine Auswerteeinrichtung zur Detektion einer Asymmetrie in der Aufteilung des Phasenstroms in die Teilströme und zur Messung eines Stromwertes,
- FIG 6: eine Auswerteeinrichtung zur Detektion einer Asymmetrie in der Aufteilung des Phasenstroms in die Teilströme, eines Kurzschlusses, eines Ausfalls eines der Leistungshalbleitermodule und zur Messung eines Stromwertes,
- FIG 7: eine Weiterbildung der Messvorrichtung der FIG 2,
- FIG 8: eine Weiterbildung der Auswerteeinrichtung der Messvorrichtung der FIG 7,
- FIG 9: eine umrichtergesteuerte Drehstrommaschine, und
- FIG 10: ein Flussdiagramm eines Verfahrens zur Inspektion und/oder Überwachung von Strom an einer Phase.

In den Ausführungsbeispielen und Figuren können gleiche oder gleich wirkende Elemente jeweils mit den gleichen Bezugszeichen versehen sein. Die dargestellten Elemente und deren Grö-βenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

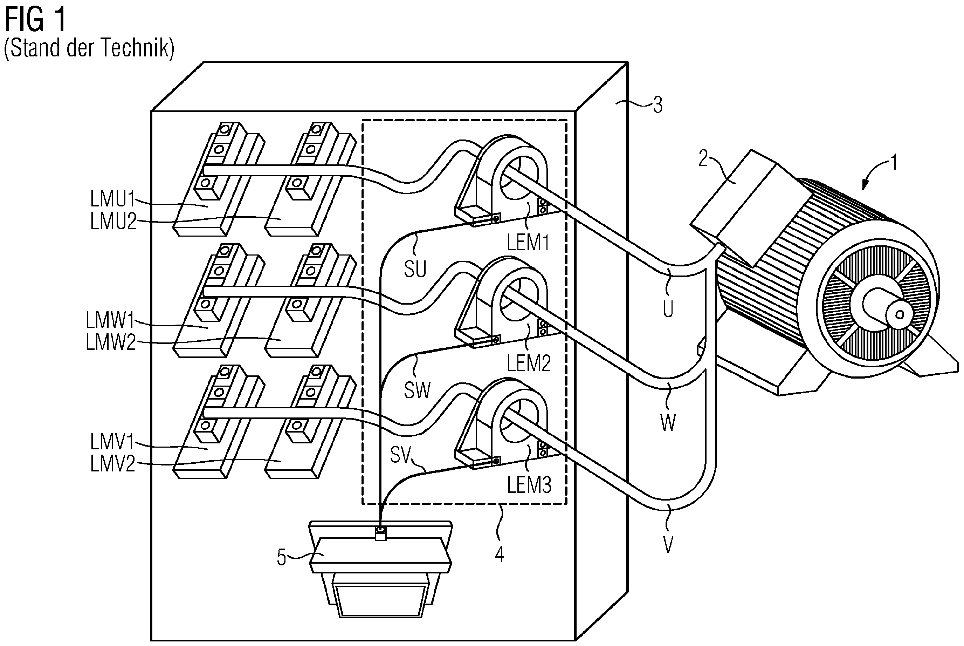

FIG 1 (Stand der Technik) zeigt eine Drehstrommaschine 1. Die Drehstrommaschine 1 ist an den Dreiphasenwechselstrom bzw. - spannung angeschlossen. Die drei Phasen U, V, W (gleicher Frequenz) werden der Drehstrommaschine 1 über den Klemmkasten 2 zugeführt und durch einen Frequenzumrichter 3 für die Versorgung der Drehstrommaschine 1 erzeugt.

Der Frequenzumrichter 3 umfasst eine herkömmliche Messvorrichtung 4, mit welcher Phasenstrom jeder Phase U, V, W gemessen werden kann und im Betrieb gemessen und einer Regelungseinheit 5 des Frequenzumrichters 3 als Strom-Istwert zugeführt wird. Der Strom-Istwert ist für die Regelung des Frequenzumrichters 3 notwendig.

Beispielhaft umfasst der Frequenzumrichter 3 sechs Leistungshalbleitermodule LMU1, LMU2, LMV1, LMV2, LMW1, LMW2: zwei Leistungshalbleitermodule je Phase U, V, W.

Die Leistungshalbleitermodule LMU1, LMU2, LMV1, LMV2, LMW1, LMW2 sind beispielsweise als IGBT (für Engl.: Insulated-Gate Bipolar Transistor) Module ausgeführt.

Zur Erfassung des Phasenstroms umfasst die Messvorrichtung 4 drei Stromwandler LEM1, LEM2, LEM3 - ein Wandler LEM1, LEM2, LEM3 je Phase U, V, W. Die Wandler können beispielsweise als Stromwandler der Firma LEM, z.B. aus der Klasse der direktabbildenden Hall-Effekt-Stromsensoren - HTA-S - ausgeführt sein.

Jeder Stromwandler LEM1, LEM2, LEM3 gibt ein analoges Signal SU, SV, SW aus, das den Phasenstrom der entsprechenden Phase U, V, W abbildet. Die analogen Signale SU, SV, SW werden der Regelungseinheit 5 zugeführt.

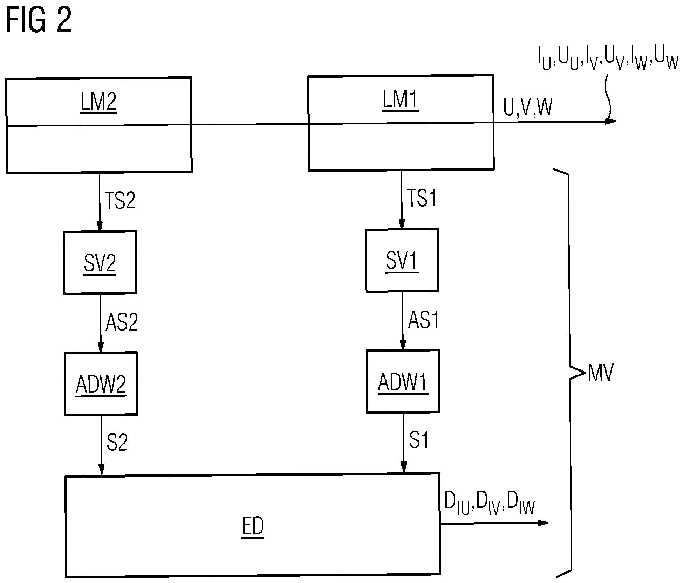

FIG 2 zeigt eine Messvorrichtung MV, die der erfindungsgemäßen Vorrichtung zur Inspektion und/oder Überwachung von Strom einer Phase entspricht. FIG 2 lässt zwei Leistungshalbleitermodule LM1 und LM2 erkennen, die beispielsweise als IGBT-Module ausgebildet sind und an einem Phasenleiter U, V, M beispielsweise eines Frequenzumrichters (hier nicht gezeigt) als parallelgeschaltete Elemente angeschlossen sind.

Insbesondere kann es vorgesehen sein, dass die Leistungshalbleitermodule LM1, LM2 ausgebildet sind, Ströme bis zu 2000 A sogar bis 3000 A (Spitzenstrom) zu schalten. Module solcher Größen werden typischerweise eingesetzt, wenn die Ströme 200 A - 300 A (400 bis 600A Spitzenstrom) übersteigen. Das kommt beispielsweise bei Frequenzumrichtern vor, die einen breiten Leistungsbereich, z.B. von 0,55 kW bis 250,00 kW und bis in Megawatt-Bereich (z.B. 1,5 MW) haben.

Der Phasenleiter U, V, W kann beispielsweise einer der drei an einer Drehstrommaschine 1 angeschlossenen Phasenleiter U, V, oder W sein und diese mit Strom I_{U}, I_{V}, I_{W}, und Spannung U_{U}, U_{V}, U_{W} versorgen.

Die Messvorrichtung MV umfasst - im vorliegenden Beispiel besteht aus - zwei Stromerfassungsvorrichtungen SV1, SV2, zwei Wandlungseinheiten ADW1, ADW2, und eine Auswerteeinrichtung ED.

Jedem Leistungshalbleitermodul LM1, LM2 ist genau eine Stromerfassungsvorrichtung SV1, SV2 zugeordnet. Jede Stromerfassungsvorrichtung SV1, SV2 erfasst einen entsprechenden Teilstrom TS1, TS2, der durch das jeweilige Leistungshalbleitermodul LM1, LM 2 fließt, und gibt ein analoges Signal AS1, AS2 aus, welches den jeweiligen Teilstrom TS1, TS2 abbildet. Dabei versteht der Fachmann, dass die Zeichnung eine rein schematische Darstellung ist und die Teilströme TS nicht am Hauptstrom vorbeifließen, sondern ein Teil des Hauptstromes sind.

Bei einer Ausführungsform kann es vorgesehen sein, dass jede Stromerfassungsvorrichtung SV1, SV2 einen oder mehr (z.B. 2, 4, 6 oder 8) Strommesswiderstände (Shuntwiderstände) aufweist bzw. als ein oder mehrere Shuntwiderstände ausgebildet ist. Es sind aber auch andere Messmethoden denkbar z.B. Mit Hall Sensoren, etc.

Es kann zweckdienlich sein, wenn die Stromerfassungsvorrichtung SV1, SV2 unmittelbar an dem genau einen, dieser Stromerfassungsvorrichtung SV1, SV2 korrespondierenden Leistungshalbleitermodul LM1, LM2 angeordnet ist oder in das korrespondierende Leistungshalbleitermodul LM1, LM2 integriert ist. Beispielsweise kann die Stromerfassungsvorrichtung SV1, SV2 und das Leistungshalbleitermodul LM1, LM2 an einem gemeinsamen Träger, beispielsweise an einer gemeinsamen Leiterplatte angebracht sein.

Bei einer Ausführungsform kann es vorgesehen sein, dass die Stromerfassungsvorrichtungen SV1, SV2 und die Leistungshalbleitermodule LM1, LM2 ein jeweils gemeinsames Gehäuse aufweisen und/oder an einem jeweils gemeinsamen Kühlkörper angeordnet sind. Dadurch ergeben sich Vorteile beim Bauraum und/oder Kühlung der Stromerfassungsvorrichtungen SV1, SV2.

Jeder Stromerfassungsvorrichtung SV1, SV2 ist jeweils eine Wandlungseinheit ADW1, ADW2 nachgeschaltet. Die Wandlungseinheiten ADW1, ADW2 können beispielsweise als A/D-Wandler, insbesondere als Sigma-Delta-Wandler ausgebildet sein und sind dazu ausgebildet, das jeweilige analoge Signal AS1, AS2 in ein digitales Signal S1, S2 umzuwandeln. Im Falle von Sigma-Delta-Wandlern sind die digitalen Signale S1, S2 1-Bit-Datenströme. Solche 1-Bit-Datenströme benötigen weniger Verbindungsleitungen und Pins an den elektronischen Bauelementen und insgesamt dadurch weniger Platz auf den Schaltungsträger. Des Weiteren sorgen die 1-Bit-Datenströme bei einem Empfänger dieser Signale für Vorteile. Beispielsweise werden am Empfänger nur zwei Pins benötigt (Bit und Clock).

Vorzugsweise werden die Sigma-Delta-Wandler mit einer Potenzialtrennungsfunktion verwendet, sodass dadurch eine mit der Umwandlung des analogen Signals in das digitale Signal gleichzeitige Potenzialtrennung des Signals ermöglicht wird.

Vorzugsweise sind die A/D-Wandler bzw. die Sigma-Delta-Wandler nicht in die entsprechende Leistungshalbleitermodule LM1, LM2 integriert. Zunächst ist die Fläche in einem Leistungshalbleitermodul LM1, LM2 z.B. in einem IGBT-Modul sehr teuer. Darüber hinaus ist die Integration eines A/D-Wandlers bzw. die Sigma-Delta-Wandlers ein sehr aufwendiger und komplizierter Prozess. Obendrein ist die Modularität an der Stelle vorteilhaft, weil z.B. die Leistungshalbleitermodule LM1, LM2 und die Wandlungseinheiten ADW1, ADW2 typischerweise unterschiedliche Lebensdauer haben.

Bei einer Ausführungsform kann es vorgesehen sein, dass die Wandlungseinheiten ADW1, ADW2, die Stromerfassungsvorrichtungen SV1, SV2 und die Leistungshalbleitermodule LM1, LM2 gemeinsam einen Teil einer elektronischen Baugruppe bilden und beispielsweise an einer gemeinsamen Leiterplatte angeordnet sind. Dies ermöglicht einen kompakten Aufbau. Darüber hinaus wird die Anzahl der Steckverbindungen reduziert. Signale können sehr gut auf den Schaltungsträger geführt werden und durch Mehrlagenaufbau effektiv geschirmt werden.

Die digitalen Signale S1, S2 beinhalten somit Informationen über die Teilströme TS1, TS2 in den Leistungshalbleitermodulen LM1, LM2. Diese Informationen sind beispielsweise in dem in FIG 1 gezeigten Stand der Technik nicht vorhanden.

Den Wandlungseinheiten ADW1, ADW2 ist die Auswerteeinrichtung ED nachgeschaltet. Der Auswerteeinrichtung ED werden die digitalen Signale S1, S2 zugeführt (Input). Die Auswerteeinrichtung ED nachgeschaltet ist dazu ausgebildet und eingerichtet, basierend auf den digitalen Signalen S1, S2 ein Ausgangssignal D_{Iu}, D_{Iv}, D_{Iw} (Output) zu erzeugen, welches eine regelungsrelevante und/oder diagnostisch relevante Information über den Strom I_{U}, I_{V}, I_{w} der Phase U, V, W trägt.

Die Art des Signals D_{Iu}, D_{Iv}, D_{Iw} und der Information kann unterschiedlich sein. Dies kann beispielsweise eine Summe, insbesondere eine Summe auf der digitalen Seite der jeweiligen Wandlungseinheit, der digitalen Signale S1, S2 sein, bei welcher die regelungsrelevante Information der Stromwert, der als Strom-Istwert für die Regelungsvorrichtung des Frequenzumrichters verwendet werden kann, oder Information über die Symmetrie der Aufteilung des Stroms I_{U}, I_{V}, I_{W} in die Teilströme TS1, TS2. Weitere Information ist denkbar.

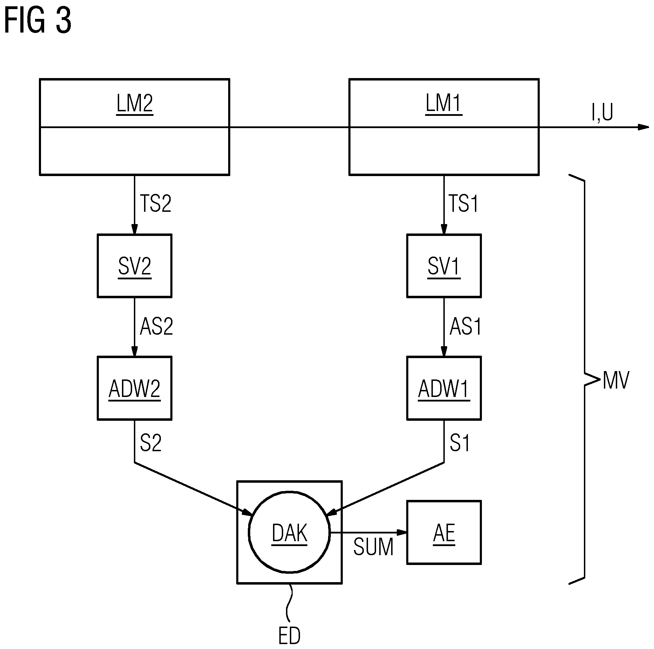

FIG 3 zeigt eine Ausführungsform der Auswerteeinrichtung ED. Die Auswerteeinrichtung ED umfasst eine digitale Additionskomponente DAK.

Die digitale Additionskomponente DAK ist dazu eingerichtet, die digitalen Signale S1, S2 miteinander zu addieren und die Summe SUM dieser Signale auszugeben.

Die digitale Additionskomponente DAK kann beispielsweise als eine Softwarekomponente ausgebildet sein. Die Auswerteeinrichtung ED kann beispielsweise ein FPGA-Modul (Engl. für *field-programmable gate array*) umfassen. Die digitale Additionskomponente DAK kann in einem solchen FPGA-Modul implementiert sein.

Im Vergleich zu der analogen Addition von Teilströmen hat die vorliegend beschriebene digitale Addition insbesondere bei großen Leistungen und Strömen (z.B. zwischen 500 A und 5000 A pro Phase) Vorteile.

Die digitale Summe SUM kann sodann einer Auswerteeinheit AE zugeführt werden, welche der Auswerteeinrichtung ED, beispielsweise dem FPGA-Modul nachgeschaltet sein kann.

Die Auswerteeinheit AE kann dazu eingerichtet sein, aus der Summe SUM einen Stromwert zu ermitteln. Die Auswerteeinheit AE kann anschließend den Stromwert (regelungsrelevante Information) als Strom-Istwert einer Regelungseinheit, vorzugsweise einer Stromregelung (hier nicht gezeigt) des Frequenzumrichters zuführen. In diesem Fall ist der Vorteil der Additionskomponente DAK besonders ersichtlich, weil durch ihre Verwendung die Anzahl der benötigten Pins, z.B. bei ASIC, FPGA oder Controller geringer ist.

Die Auswerteeinheit AE kann als eine digitale Auswerteeinheit, insbesondere als eine digitale Auswerteschaltung, beispielsweise eine anwendungsspezifische integrierte Schaltung - ASIC (Engl. für: application-specific integrated circuit) - ausgebildet sein.

Die digitale Addition der Signale S1, S2 ist besonders vorteilhaft, wenn solche digitalen Auswerteschaltungen, beispielsweise ASICs verwendet werden. Bei den digitalen Auswerteschaltungen ist die Anzahl der Pins typischerweise begrenzt. Pro jedes digitale Signal S1, S2 sind mindestens zwei Pins notwendig. Die Anzahl der Pins ist dabei ein wichtiger Parameter, der nur schwer beeinflusst werden kann, und würde mit der Anzahl der digitalen Signale S1, S2 linear ansteigen. Die digitale Additionseinheit DAK bietet eine simple Lösung für dieses Problem.

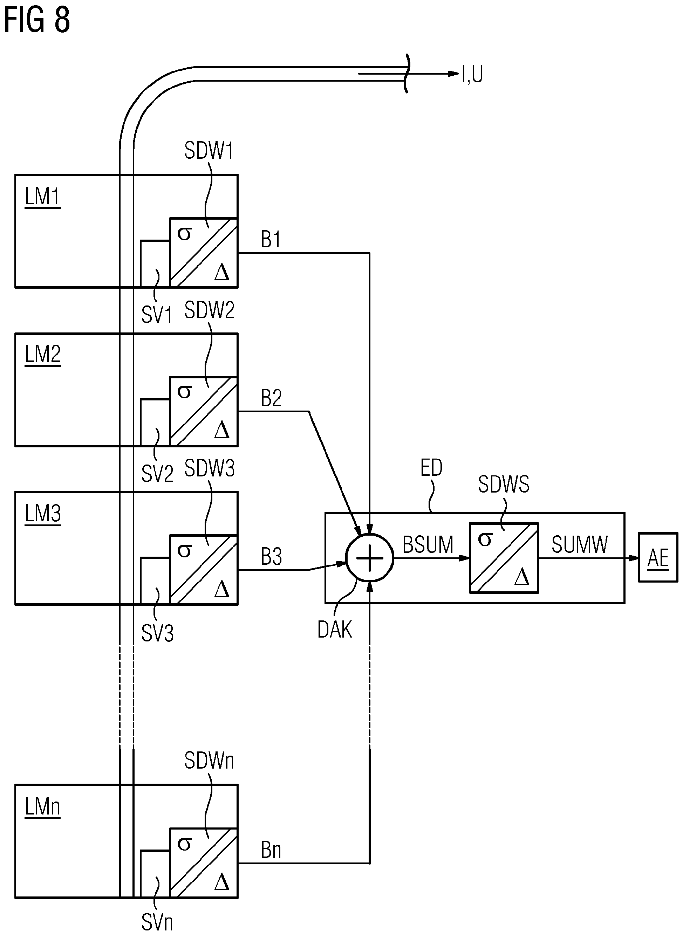

Die Auswerteeinrichtung ED kann darüber hinaus einen A/D-Wandler, beispielsweise einen Sigma-Delta-Wandler umfassen, dem die digitale Summe SUM der Signale S1, S2 zugeführt wird. Ein solcher Wandler ist in FIG 3 zwar nicht gezeigt. Er ist aber bei einer weiteren Ausführungsform der FIG 8 zu sehen (der Wandler SDSW) und hat die gleiche Funktion. Ist dieser Wandler SDSW als Sigma-Delta-Wandler ausgeführt, so wird der Auswerteeinheit AE ein 1-Bit-Datenstrom zugeführt. Dadurch kann die Anzahl der Pins, die bei der Auswerteeinheit AE notwendig sind, um das Signal zu empfangen, das die Informationen über den Strom I_{U}, I_{V}, I_{W} der Phase U, V, W trägt, minimiert werden.

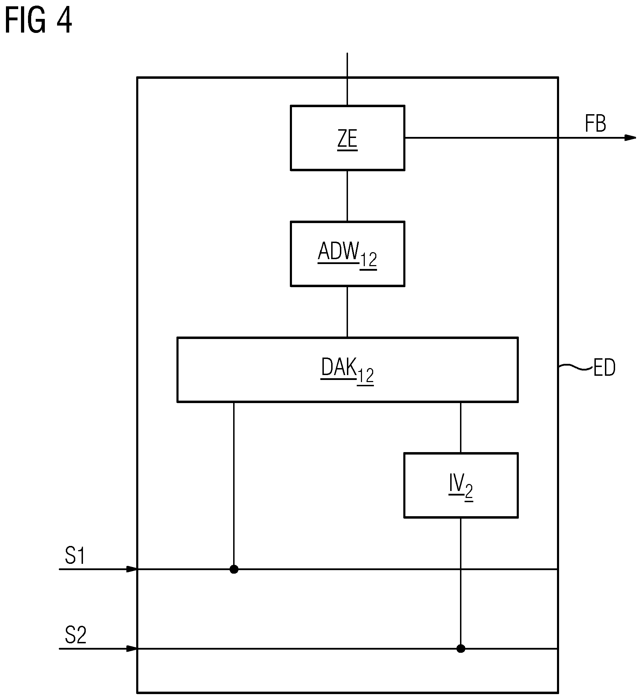

FIG 4 zeigt eine weitere Ausführungsform der Auswerteeinrichtung ED. Die Auswerteeinrichtung ED erhält die digitalen Signale als Input und erzeugt ein Fehlerbit-Signal FB als Output. Das Fehlerbit-Signal FB trägt eine Information über die Symmetrie der Aufteilung des Stroms I_{U}, I_{V}, I_{W} der Phase U, V, W auf die Teilströme TS1, TS2.

Hierzu kann die Auswerteeinrichtung ED beispielsweise folgende (Hard- oder Software-)Komponenten umfassen: eine Inverterkomponente IV₂, eine (weitere) digitale Additionskomponente DAK₁₂, eine (optionale) Wandlungseinheit ADW₁₂ und eine Zählereinheit ZE.

Eine oder mehrere dieser Komponenten können in einem FPGA-Modul implementiert sein.

FIG 4 lässt die Funktionen der einzelnen Komponenten gut erkennen. Die Inverterkomponente IV₂ ist dazu konfiguriert, eines der beiden digitalen Signale S1, S2 - vorliegend das zweite Signal S2 - zu invertieren und das Ergebnis der digitalen Additionskomponente DAK₁₂ zuzuführen, welche das Ergebnis des Umkehrens und das nicht invertierte Signal - hier das Signal S1 - addiert.

Das Ergebnis der Addition kann einer optionalen Wandlungseinheit ADW₁₂ zugeführt werden. Die Wandlungseinheit ADW₁₂ kann als ein A/D- und insbesondere als ein Sigma-Delta-Wandler ausgebildet sein.

Wenn die digitalen Signale S1, S2 1-Bit-Datenströme sind, ist das Ergebnis der Addition durch die digitale Additionskomponente DAK₁₂ ein 2-Bit-Datenstrom, der optional durch einen Sigma-Delta-Wandler in ein 1-Bit-Datenstrom umgewandelt werden kann.

Die Zählereinheit ZE ist dazu eingerichtet, das Signal von der digitalen Additionskomponente DAK₁₂ zu empfangen und dieses auszuwerten, um eventuelle Abweichungen von einer symmetrischen Verteilung der Teilströme TS1, TS2 zu detektieren.

Sind die digitalen Signale S1 und S2 symmetrisch, ist das Ergebnis der digitalen Addition gleich null. Die Zählereinheit ZE erzeugt ein entsprechendes Fehlerbit-Signal FB, dass z.B. ebenfalls gleich null ist. Sind die digitalen Signale S1 und S2 unsymmetrisch, ist das Ergebnis der digitalen Addition von null verschieden. Die Zählereinheit ZE erzeugt in diesem Fall auch ein charakteristisches Fehlerbit-Signal FB.

Wenn die Wandlungseinheit ADW₁₂ vorhanden und als ein Sigma-Delta-Wandler ausgebildet ist, zählt die Zählereinheit ZE Nullen und Einsen.

Es ist anzumerken, dass die vorstehend beschriebene digitale Additionskomponente DAK in dem gleichen FPGA-Modul implementiert werden kann, so dass die Auswerteeinrichtung ED gleichzeitig zwei Ausgangssignale ausgeben kann: die digitale Summe SUM und das Fehlerbit-Signal FB.

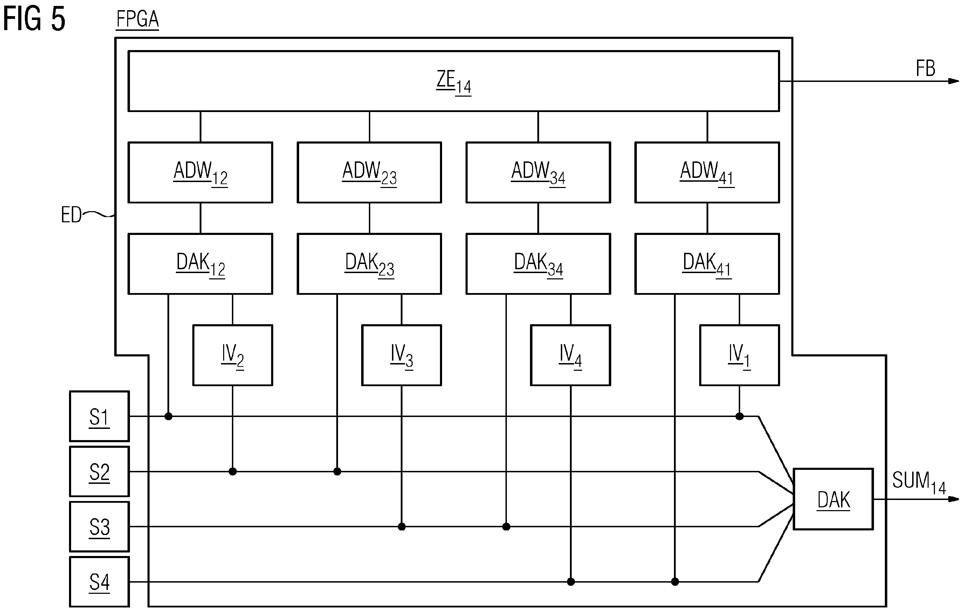

Dieser Aspekt ist in FIG 5 veranschaulicht. FIG 5 zeigt eine Erweiterung der Ausführungsform der Auswerteeinrichtung ED der FIG 4 auf vier digitale Signale S1, S2, S3, S4, wobei die Auswerteeinrichtung ED vier Inverterkomponenten IV₁, IV₂, IV₃, IV₄, vier weiteren digitalen Additionskomponente DAK₁₂, DAK₂₃, DAK₃₄, DAK₄₁, und vier (optionalen) Wandlungseinheiten ADW₁₂, ADW₂₃, ADW₃₄, ADW₄₁ aufweist und dazu eingerichtet ist, die Symmetrie der Stromaufteilung auf die digitalen Signale S1 bis S4 zu überprüfen, indem diese paarweise zyklisch untersucht werden. Jedes Signal-Paar S1-S2, S2-S3, S3-S4, S4-S1 wird dabei wie in Bezug auf FIG 4 beschrieben aufsummiert.

Die Zählereinheit ZE₁₄ ist beispielsweise dazu eingerichtet, die Signale von den digitalen Additionskomponente DAK₁₂, DAK₂₃, DAK₃₄, DAK₄₁, zu empfangen und diese auszuwerten, um eventuelle Abweichungen von einer symmetrischen Verteilung der vier Teilströme zu detektieren.

Darüber hinaus umfasst die Auswerteeinrichtung ED der FIG 5 die digitale Additionskomponente DAK, welche die digitalen Signale S1 bis S4 miteinander addiert und die digitale Summe SUM₁₄, beispielsweise bei einer vorherigen Modulation durch einen A/D- und insbesondere durch einen Sigma-Delta-Wandler der Auswerteeinheit AE (hier nicht gezeigt) zuführt.

Die Auswerteeinrichtung ED ist beispielsweise als ein FPGA-Modul ausgebildet.

Die Auswerteeinrichtung ED kann beispielsweise eine oder mehrere Schnittstellen aufweisen, welche ein oder mehrere Kommunikationsprotokolle, beispielsweise SPI und/oder I2C unterstützen. Diese Schnittstellen können ein Teil des FPGA-Moduls sein.

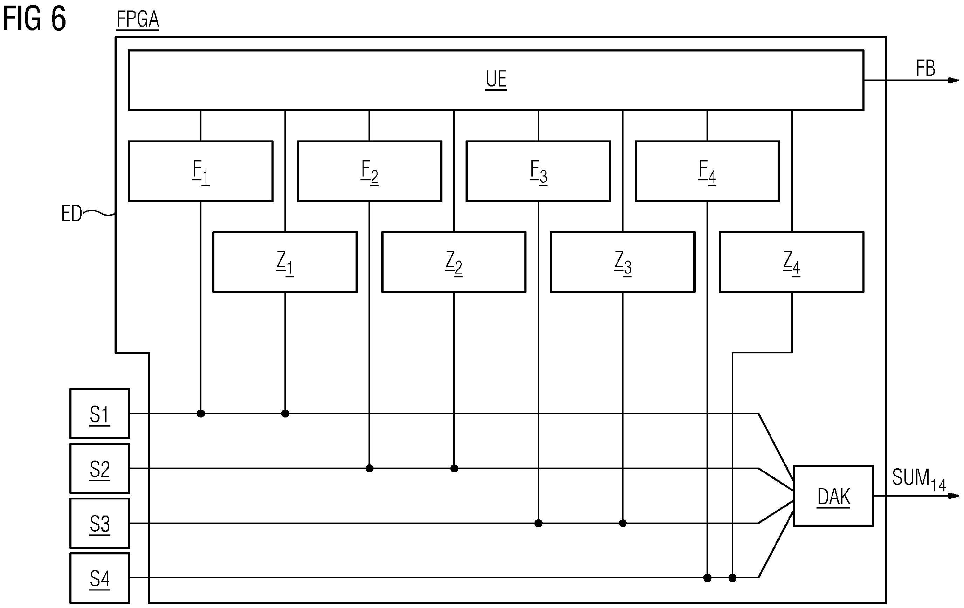

FIG 6 zeigt eine weitere Ausführungsform der Auswerteeinrichtung ED zum Überwachen der Symmetrie der Aufteilung des Phasenstroms I_{U}, I_{V}, I_{W} auf die entsprechenden Teilströme.

Die Auswerteeinrichtung ED ist also dazu ausgebildet, eine Asymmetrie in der Aufteilung des Phasenstroms I_{U}, I_{V}, I_{W} in die Teilströme zu detektieren. Darüber hinaus kann Auswerteeinrichtung ED zusätzlich oder alternativ dazu ausgebildet sein, einen Kurzschluss, einen Ausfall eines der (hier vier) Leistungshalbleitermodule zu detektieren, und ein Signal SUM₁₄ für eine unmittelbare Stromwertmessung auszugeben.

Pro Digitalsignal S1, S2, S3, S4, welches von je einem Leistungshalbleitermodul kommt, sieht die hier ebenfalls als ein FPGA-Modul ausgeführte Auswerteeinrichtung ED je eine Zählervorrichtung Z1, Z2, Z3, Z4 und eine Filtervorrichtung F1, F2, F3, F4 vor. vorzugsweise jeder Filtervorrichtung ist dazu eingerichtet, den seriellen, der jeweiligen Filtervorrichtung zugeführten Sigma-Delta-Datenstrom in einen "Digitalen Wert" des aktuellen Stromwertes z.B. 1024 (Bitwert) umzuwandeln. Vorzugsweise jede Zählervorrichtung ist dazu eingerichtet, den Bitstrom auf aufeinanderfolgende Einser zu überwachen. Übersteigt die Anzahl der aufeinanderfolgenden Einser eine vorgegebene Schranke, kann das bedeuten, dass der Messstrom zu hoch ist und man von einem Fehlerfall ausgehen muss.

Die Ergebnisse des Zählens und des Filterns können anschließend einer Überwachungseinheit UE zugeführt werden, die das System auf Symmetrie, Kurzschluss, Ausfall eines oder mehrere Digitalsignale S1, S2, S3, S4, etc. überwacht und diese detektieren kann. Werden beispielsweise 10 aufeinanderfolgende Einser gezählt, kann dies als Überstromereignis definiert werden, sodass daraus mit einer überwiegenden Wahrscheinlichkeit auf einen Kurzschluss rückgeschlossen werden kann.

Es versteht sich, dass die Anzahl der Leistungshalbleitermodule und somit der digitalen Signale in den Figuren 4-6 gezeigten Ausführungsformen ohne Weiteres erhöht werden kann. Das heißt, dass es genauso gut fünf, sechs, sieben, acht usw. Leistungshalbleitermodule pro Phase vorgesehen sein können und fünf, sechs, sieben, acht usw. digitale Signale verarbeitet untersucht werden können, um eine Asymmetrie in der Aufteilung des Phasenstroms in die Teilströme I_{U}, I_{V}, I_{W} zu ermitteln ein Signal SUM₁₄ für eine unmittelbare Stromwertmessung auszugeben.

Die Information darüber, ob die Aufteilung der Ströme symmetrisch oder unsymmetrisch ist, kann beispielsweise für prädiktive Wartung verwendet werden. Insofern ist diese Information diagnostisch relevant.

Eine unsymmetrische Aufteilung der Ströme S1, S2, S3, S4 usw. zwischen den parallelgeschalteten Leistungsmodulen LM1, LM2, ... kann zu einer höheren Belastung einzelner Leistungsmodule LM1, LM2, ... in der Parallelschaltung führen. Eine höhere Belastung wiederum verringert die Lebensdauer, des mit einem höheren Strom belasteten Leistungsmoduls und kann zu einem vorzeitigen Ausfall führen. Die höhere Belastung eines Leistungsmoduls kann mit herkömmlichen Methoden nur umständlich erkannt werden, da keine Information über die Stromaufteilung zwischen den parallelgeschalteten Leistungsmodulen LM1, LM2, ... vorliegt. Zu einem Ausfall kann es je nach Höhe der Asymmetrie erst nach langer Zeit kommen (Monate oder Jahre).

Mit der in dem Fehlerbit-Signal FB enthaltenen Information über die Symmetrie der Aufteilung des Stroms I_{U}, I_{V}, I_{W} der Phase U, V, W auf die Teilströme TS1, TS2 ist es möglich, die Teilströme TS1, TS2 auf Asymmetrie zu überwachen und lange Zeit vor einem Ausfall (prädiktiv) eine Meldung zu erzeugen, dass ein nicht erwünschter Betriebszustand vorliegt und eine Wartung bzw. Untersuchung durch einen Servicetechniker vorgenommen werden soll.

Es wird angemerkt, dass in der vorliegenden Offenbarung beschriebene Inspektion und/oder Überwachung im Betrieb fortlaufend durchgeführt wird. So werden beispielsweise die digitalen Signale fortlaufend auf Symmetrie überprüft und/oder digital addiert.

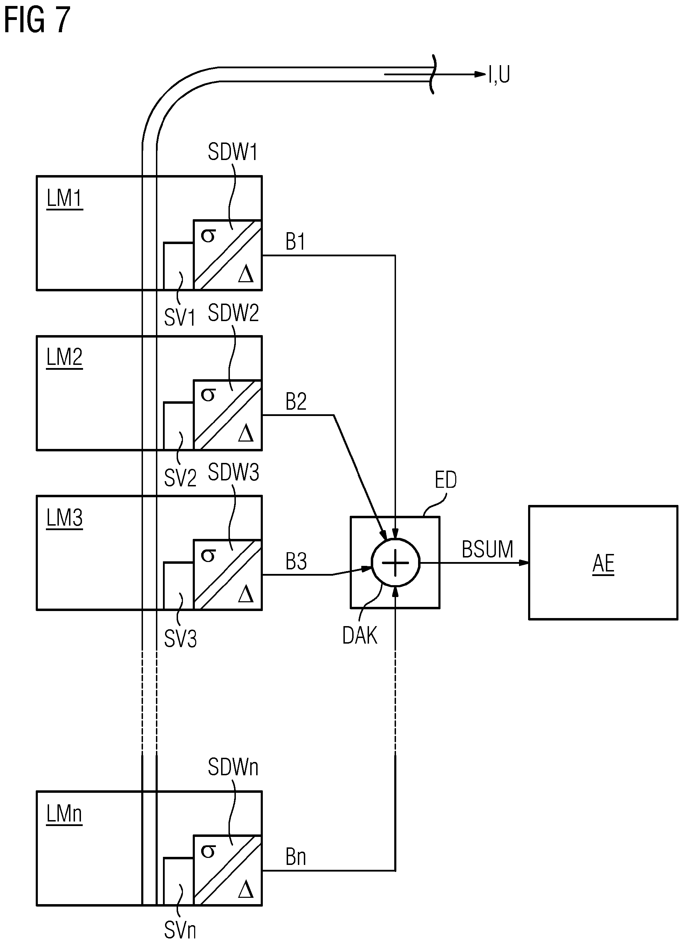

FIG 7 zeigt eine Weiterbildung der Messvorrichtung MV der FIG 2 auf den allgemeinen Fall, wenn pro Phase U, V, W n parallelgeschaltete, beispielsweise als IGBT-Module ausgebildete Leistungshalbleitermodule vorgesehen sind, wobei n = 2, 3, 4, 5, 6, ... 10, ... ist.

Pro Leistungshalbleitermodul LM1, LM2, ... LMn ist jeweils eine Stromerfassungsvorrichtung SV1, SV2, ... SVn vorgesehen, die beispielsweise in das entsprechende Leistungshalbleitermodul LM1, LM2, ... LMn integriert ist.

Die A/D-Wandler sind vorliegend als Sigma-Delta-Wandler SDW1, SDW2, ... SDWn ausgebildet. Die Anzahl n der Sigma-Delta-Wandler ist der Anzahl n der Leistungshalbleitermodule und der Stromerfassungsvorrichtungen gleich. Pro Leistungshalbleitermodul LM1, LM2, ... LMn bzw. pro Stromerfassungsvorrichtung SV1, SV2, ... SVn ist jeweils ein Sigma-Delta-Wandler SDW1, SDW2, ... SDWn vorgesehen.

Die Sigma-Delta-Wandler SDW1, SDW2, ... SDWn sind beispielsweise in die entsprechenden Leistungshalbleitermodule LM1, LM2, ... LMn integriert (müssen aber nicht), befinden sich allerdings vorzugsweise in unmittelbarer Nähe des entsprechenden Leistungshalbleitermoduls, z.B. auf einem gemeinsamen als eine Leiterplatte ausgebildeten Träger.

Das Signal am Ausgang eines jedes Sigma-Delta-Wandlers SDW1, SDW2, ... SDWn ist ein 1-Bit-Datenstrom B1, B2, ... Bn.

Die digitale Additionskomponente DAK summiert die 1-Bit-Datenströme B1, B2, ... Bn auf und führt ein n-Bit-Datenstrom BSUM der Auswerteeinheit AE zu. Die Auswerteeinrichtung ED umfasst somit die digitale Additionskomponente DAK. Die Auswerteeinrichtung ED kann als ein FPGA-Modul ausgebildet sein.

Eine oder mehrere der Stromerfassungsvorrichtungen SV1, SV2, ... SVn können einen oder mehrere Shuntwiderstände umfassen. In Kombination mit der digitalen Addition, die durch die digitale Additionskomponente DAK durchgeführt wird, hat dies besondere Vorteile bezüglich der Störfestigkeit und der Übertragung bis zu Regelungseinheit.

FIG 8 ist zu entnehmen, dass die Auswerteeinrichtung ED einen weiteren Sigma-Delta-Wandler SDWS umfassen kann. Der Sigma-Delta-Wandler SDWS ist der digitale Additionskomponente DAK nachgeschaltet und dazu ausgebildet, den n-Bit-Datenstrom BSUM in einen 1-Bit-Datenstrom SUMW umzuwandeln, der der Auswerteeinheit AE zugeführt wird. Die Auswerteeinheit AE ermittelt aus dem 1-Bit-Datenstrom SUMW einen Strom-Istwert, und führt diesen der Regelungseinheit des Frequenzumrichters zu.

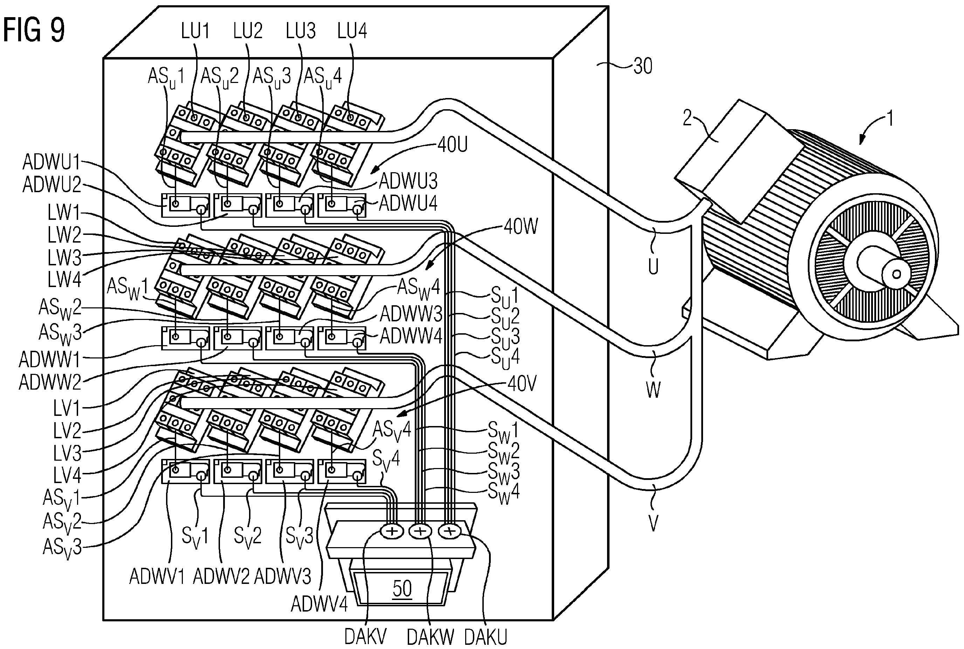

FIG 9 zeigt eine dreiphasige Drehstrommaschine 1, die von einem Frequenzumrichter 30 versorgt wird. Die Phasen U, V, W werden im Klemmkasten 2 angeschlossen.

Der Frequenzumrichter 30 weist insgesamt zwölf beispielsweise als IGBT-Module ausgebildete Leistungshalbleitermodule - vier parallelgeschaltete Leistungshalbleitermodule pro Phase: LU1, LU2, LU3, LU4 für die Phase U, LV1, LV2, LV3, LV4 für die Phase V, und LW1, LW2, LW3, LW4 für die Phase W.

FIG 9 lässt erkennen, dass der Frequenzumrichter 30 drei Vorrichtungen 40U, 40V, 40W umfasst, wobei jede Vorrichtung 40U, 40V, 40W zur Inspektion und/oder Überwachung des Stroms an der jeweiligen Phase U, V, W vorgesehen ist.

Jede Vorrichtung 40U, 40V, 40W gemeinsam mit den entsprechenden Leistungshalbleitermodulen LU1, LU2, LU3, LU4; LV1, LV2, LV3, LV4; LW1, LW2, LW3, LW4 können beispielsweise eine elektronische Baugruppe bilden und somit auf einem gemeinsamen Träger angebracht sein, welcher beispielsweise als eine Leiterplatte ausgebildet ist.

Die Stromerfassungsvorrichtungen sind in die jeweiligen Leistungshalbleitermodule integriert und sind in FIG 9 nicht sichtbar. Gezeigt sind die analogen Signale AS_{U}1, AS_{U}2, AS_{U}3, AS_{U}4, AS_{W}1, AS_{W}2, AS_{W}3, AS_{W}4, AS_{V}1, AS_{V}2, AS_{V}3, AS_{V}4, die die jeweiligen (hier aus Platzgründen nicht gezeigten) Stromerfassungsvorrichtungen ausgeben. Die analogen Signale AS_{U}1, AS_{U}2, AS_{U}3, AS_{U}4, AS_{W}1, AS_{W}2, AS_{W}3, AS_{W}4, AS_{V}1, AS_{V}2, AS_{V}3, AS_{V}4 werden den entsprechenden A/D-Wandlern ADWU1, ADWU2, ADWU3, ADWU4, ADWW1, ADWW2, ADWW3, ADWW4, ADWV1, ADWV2, ADWV3, ADWV4 zugeführt, von denen es wiederum vier pro Phase U, V, W vorgesehen sind.

FIG 9 ist zu entnehmen, dass jedem Leistungshalbleitermodul LU1, LU2, LU3, LU4, LV1, LV2, LV3, LV4, LW1, LW2, LW3, LW4 jeweils genau ein A/D-Wandler ADWU1, ADWU2, ADWU3, ADWU4, ADWW1, ADWW2, ADWW3, ADWW4, ADWV1, ADWV2, ADWV3, ADWV4 korrespondiert, um das entsprechende analoge Signal AS_{U}1, AS_{U}2, AS_{U}3, AS_{U}4, AS_{W}1, AS_{W}2, AS_{W}3, AS_{W}4, AS_{V}1, AS_{V}2, AS_{V}3, AS_{V}4 in das entsprechende digitale Signal S_{U}1, S_{U}2, S_{U}3, S_{U}4, S_{W}1, S_{W}2, S_{W}3, S_{W}4, S_{V}1, S_{V}2, S_{V}3, S_{V}4, umzuwandeln.

Die einer bestimmten Phase entsprechenden digitalen Signale - hier vier digitale Signale AS_{X}1, AS_{X}2, AS_{X}3, AS_{X}4, pro Phase, wobei X = U, V, W - werden der entsprechenden digitalen Additionskomponente DAKU, DAKW, DAKV zugeführt.

Vorzugsweise ist die Anzahl der digitalen Signale je Phase gleich der Anzahl der parallelgeschalteten Leistungshalbleitermodule.

Die digitalen Signale sind beispielsweise 1-Bit-Datenströme.

FIG 9 lässt die jeweiligen digitalen Additionskomponenten DAKU, DAKW, DAKV erkennen. Die die entsprechenden digitalen Signale addieren und die Summe einer Regelungseinheit 50 zuführen.

Wie bereits erörtert kann eine oder mehrere digitale Additionskomponenten DAKU, DAKW, DAKV in einem FPGA-Modul implementiert sein, welches optional einen Sigma-Delta-Wandler umfasst, um aus einem n-Bit-Datenstrom einen 1-Bit-Datenstrom zu erzeugen, der einer ASIC, einem (weiteren) FPGA-Modul beziehungsweise einem Controller (Auswerteeinheit) zugeführt werden kann. Die Stromregelung 50 des Frequenzumrichters 30 kann somit den Strom-Istwert von der ASIC bereitgestellt bekommen.

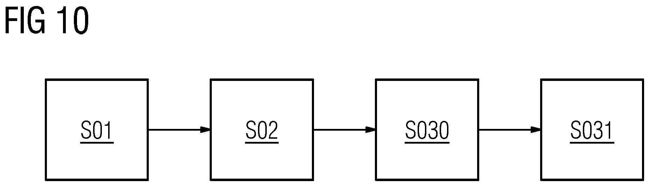

FIG 10 zeigt ein Flussdiagramm eines Verfahrens zur Inspektion und/oder Überwachung von Strom an einer Phase. Dabei kann beispielsweise eine in den Figuren 2 bis 9 beschriebene Vorrichtung eingesetzt werden.

In einem Schritt S01 wird ein Teilstroms an jedem der mindestens zwei Leistungshalbleitermodule erfasst. Dabei werden (mindestens zwei) analoge Signale erzeugt, wobei jedes analoge Signal dem jeweiligen Teilstrom korrespondiert bzw. den jeweiligen Teilstrom abbildet. Vorzugsweise wird pro Leistungshalbleitermodule jeweils genau ein analoges Signal erzeugt.

In einem Schritt S02 wird jedes analoge Signal in ein digitales Signal umgewandelt. Vorzugsweise erfolgt dabei eine Potenzialtrennung des analogen Signals.

In einem Schritt S030 können die digitalen Signale digital addiert werden, um eine digitale Signalsumme zu erzeugen.

In einem Schritt S031 wird ein Stromwert für die Phase aus der digitalen Signalsumme ermittelt.

Alternativ oder zusätzlich zu den Schritten S030, S031 können aus den parallel verlaufenden digitalen Signalen Informationen über die Symmetrie der Aufteilung des Phasenstroms auf die Teilströme ermittelt werden, die zur Inspektion und/oder Überwachung des Phasenstroms und somit des "Gesundheitszustandes" der einzelnen Leistungshalbleitermodule verwendet werden kann. Daraus kann auch auf den Gesundheitszustand des Gesamtsystems z.B. Schraubverbindungen im Stromflusspfad, thermischer Kontakt Modul Kühlkörper, Verschmutzung Kühlkörper, Lüfterleistung etc. rückgeschlossen werden.

Bei der Überwachung der Symmetrie kann beispielsweise ein Schwellwert festgelegt werden, dessen Überschreitung protokolliert wird. Dabei kann beispielsweise zwischen dynamischer und statischer Überschreitung unterschieden werden. Dynamisch (kurzzeitig bei Schalthandlungen) können größere Asymmetrien zulässig sein (z.B. bis zu 30%). Stationär (nach der Schalthandlung und dem Abklingen des Ausgleichvorgangs) sollte die Asymmetrie geringer sein (z.B. < 5%). Neben der Protokollierung, dass der Schwellwert überschritten wurde, kann auch die Anzahl der Überschreitungen und, vorzugsweise in welchem Teil Teilstrom diese sich ereignen, protokolliert werden, um so den Fehler besser lokalisieren zu können. Die Höhe der Überschreitung und der Zeitpunkt der Überschreitungen können ebenfalls festgehalten werden.

Des Weiteren ist es denkbar, dass die ermittelte Information über die Teilströme (Wert, Symmetrie der Verteilung, etc.) einem (beispielsweise trainierten) Lebensdauermodell der Leistungshalbleitermodule, welches ermittelt, inwieweit die Lebensdauer reduziert wird, bzw. welche Restlebensdauer noch besteht. Unterschreitet die Restlebensdauer einen kritischen (vorbestimmten) Schwellwert, so kann eine Warnung erzeugt werden und ein Serviceeinsatz (prädiktiv) geplant werden.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

## Patentansprüche

1. Vorrichtung zur Inspektion und/oder Überwachung eines Stroms (I_{U}, I_{V}, I_{W}) einer Phase (U, V, W) in einer Leistungselektronik-Vorrichtung (30), wobei die Leistungselektronik-Vorrichtung (30) mindestens zwei Leistungshalbleitermodule (LM1, LM2) aufweist, wobei die mindestens zwei Leistungshalbleitermodule (LM1, LM2) an der Phase (U, V, W) parallelgeschaltet angeordnet sind, wobei die Vorrichtung (MV) mindestens zwei Stromerfassungsvorrichtungen (SV1, SV2), mindestens zwei Wandlungseinheiten (ADW1, ADW2), und eine Auswerteeinrichtung (ED) umfasst, wobei
- jede Stromerfassungsvorrichtung (SV1, SV2) dazu ausgebildet ist, einen Teilstrom (TS1, TS2) an jeweils einem Leistungshalbleitermodul (LM1, LM2) der an der Phase (U, V, W) parallelgeschaltet angeordneten Leistungshalbleitermodule (LM1, LM2) zu erfassen und ein analoges Signal (AS1, AS2), das mit dem erfassten Teilstrom (TS1, TS2) korrespondiert, auszugeben, wobei eine Summe aller erfassten Teilströme (TS1, TS2) den Strom (I_{U}, I_{V}, I_{W}) in der Phase (U, V, W) ergibt, wobei
- jede Wandlungseinheit (ADW1, ADW2) jeweils einer Stromerfassungsvorrichtung (SV1, SV2) nachgeschaltet ist und dazu ausgebildet ist, das analoge Signal (AS1, AS2) in ein digitales Signal (S1, S2) umzuwandeln, wobei
- die Auswerteeinrichtung (ED) den mindestens zwei Wandlungseinheiten (ADW1, ADW2) nachgeschaltet ist und dazu ausgebildet und eingerichtet ist, basierend auf den digitalen Signalen (S1, S2) ein Ausgangssignal (D_{Iu}, D_{Iv}, D_{Iw}) zu erzeugen, welches eine regelungsrelevante und/oder diagnostisch relevante Information über den Strom (I_{U}, I_{V}, I_{W}) der Phase (U, V, W) enthält.

2. Vorrichtung nach Anspruch 1, wobei jede Stromerfassungsvorrichtung zumindest einen Strommesswiderstand, vorzugsweise zwei oder mehr Strommesswiderstände, oder einen Stromsensor, beispielsweise einen GMR-Sensor oder einen Hall-Sensor aufweist.

3. Vorrichtung nach Anspruch 1 oder 2, wobei das Ausgangssignal eine digitale Summe (SUM) der Teilströme (TS1, TS2) ist.

4. Vorrichtung nach Anspruch 3, wobei die Auswerteeinrichtung (ED) eine digitale Additionskomponente (DAK) aufweist, wobei die digitale Additionskomponente (DAK) dazu konfiguriert ist, die digitalen Signale (S1, S2) miteinander zu addieren.

5. Vorrichtung nach einem der Ansprüche 1 bis 4, wobei die Auswerteeinrichtung (ED) eine weitere Wandlungseinheit (ADW₁₂, SDWS) aufweist.

6. Vorrichtung nach einem der Ansprüche 1 bis 5, wobei das Ausgangssignal eine Information über die Symmetrie der Aufteilung des Stroms (I_{U}, I_{V}, I_{W}) der Phase (U, V, W) auf die Teilströme (TS1, TS2) trägt.

7. Vorrichtung nach einem der Ansprüche 1 bis 6, wobei zumindest eine, vorzugsweise jede Wandlungseinheit als ein Sigma-Delta-Wandler ausgebildet ist, welche einen 1-Bit-Datenstrom ausgibt.

8. Elektronische Baugruppe, umfassend mindestens zwei parallelgeschaltete Leistungshalbleitermodule (LM1, LM2) und eine Vorrichtung nach einem der Ansprüche 1 bis 7.

9. Baugruppe nach Anspruch 7, wobei die mindestens zwei Stromerfassungsvorrichtungen und/oder die mindestens zwei Wandlungseinheiten in die Leistungshalbleitermodule integriert sind.

10. Baugruppe nach Anspruch 8 oder 9 umfassend mehr als zwei Leistungshalbleitermodule und wobei die Anzahl der Stromerfassungsvorrichtungen und die Anzahl der Wandlungseinheiten jeweils gleich der Anzahl der Leistungshalbleitermodule ist.

11. Baugruppe nach einem der Ansprüche 8 bis 10, wobei die Baugruppe einen als eine Leiterplatte ausgebildeten Träger aufweist, an dem die mindestens zwei parallelgeschalteten Leistungshalbleitermodule (LM1, LM2), die mindestens zwei Stromerfassungsvorrichtungen (SV1, SV2), und die mindestens zwei Wandlungseinheiten (ADW1, ADW2) angebracht sind.

12. Baugruppe nach Anspruch 11, wobei die Auswerteeinrichtung (ED) an dem Träger angebracht ist.

13. Umrichter, insbesondere Frequenzumrichter umfassend eine elektronische Baugruppe nach einem der Ansprüche 8 bis 12.

14. Verfahren zur Inspektion und/oder Überwachung eines Stroms an einer Phase, wobei an der Phase mindestens zwei Leistungshalbleitermodule parallelgeschaltet sind, umfassend folgende Schritte:
S01: Erfassen eines Teilstroms an jedem der mindestens zwei Leistungshalbleitermodule, wobei eine Summe aller erfassten Teilströme (TS1, TS2) den Strom (I_{U}, I_{V}, I_{W}) in der Phase (U, V, W) ergibt, um analoge, den jeweiligen Teilströmen korrespondierende Signale zu erzeugen;
S02: Umwandeln eines jeden analogen Signals in ein digitales Signal;
S03: Ermitteln aus den digitalen Signalen (S1, S2) zumindest einer regelungsrelevanten und/oder diagnostisch relevanten Information über den Strom (I_{U}, I_{V}, I_{W}) der Phase (U, V, W).

15. Verfahren nach Anspruch 14, wobei das Ermitteln (S03) umfasst:
S030: Digitales Addieren der digitalen Signale;
S031: Ermitteln eines Stromwertes für die Phase aus dem Ergebnis des digitalen Addierens der digitalen Signale.
